Europäisches Patentamt

European Patent Office

Office européen des brevets

(11) Veröffentlichungsnummer: **0 222 348**

**A2**

(12) **EUROPÄISCHE PATENTANMELDUNG**

(21) Anmeldenummer: **86115485.4**

(22) Anmeldetag: **07.11.86**

(51) Int. Cl.⁴: **C23F 1/08**

(30) Priorität: **11.11.85 DE 3539874**

(43) Veröffentlichungstag der Anmeldung:
**20.05.87 Patentblatt 87/21**

(84) Benannte Vertragsstaaten:
**AT BE CH DE FR GB IT LI NL SE**

(71) Anmelder: **HANS HÖLLMÜLLER MASCHINENBAU GMBH & CO.**
**Kappstrasse 69**
**D-7033 Herrenberg(DE)**

(72) Erfinder: **Haas, Rainer**
**Filsstrasse 6**
**D-7033 Herrenberg(DE)**

(74) Vertreter: **Ostertag, Ulrich et al**
**Patentanwälte Dr. Ulrich Ostertag Dr.**
**Reinhard Ostertag Eibenweg 10**
**D-7000 Stuttgart 70(DE)**

(54) **Anlage zum Ätzen von zumindest teilweise aus Metall, vorzugsweise Kupfer, bestehendem Ätzgut.**

(57) Bei einer Anlage zum Ätzen von zumindest teilweise aus Metall, vorzugsweise Kupfer, bestehendem Ätzgut wird dem eine Säure enthaltenden Ätzmittel unmittelbar vor dem eigentlichen Ätzvorgang Oxidationsmittel in einer Menge zugegeben, die in Bezug zu derjenigen Menge steht, die nach stöchiometrischer Berechnung zum Abätzen der jeweils am Ätzgut abzutragenden Metallmenge erforderlich ist. Hierzu ist eine Einrichtung vorhanden, welche ein erstes elektrisches Signal abgibt. Dieses gibt Auskunft über die Menge des abzutragenden Materials am jeweils bearbeiteten Ätzgut. Ein zweites Signal wird von einem Detektor dann ausgesandt, wenn das Ätzgut in die eigentliche Ätzmaschine einläuft. Beide Signale werden von einer zentralen Steuereinheit verarbeitet. Dies geschieht in der Weise, daß die zentrale Steuereinheit ein drittes Signal abgibt, welches es nach einem abgespeicherten Programm aus dem erste Signal ermittelt hat, und zwar dann, wenn das Detektorsignal empfangen wird. Das dritte Signal entspricht der jeweils gewünschten Menge Oxidationsmittel und beaufschlagt eine Dosiereinrichtung, welche dann die Abmessung der Oxidationsmittelmenge vornimmt. In derselben Weise kann dem Ätzmittel zur Regeneration in stöchiometrisch definierter Menge Säure zugegeben werden.

# Anlage zum Ätzen von zumindest teilweise aus Metall, vorzugsweise Kupfer, bestehendem Ätzgut

Die Erfindung betrifft eine Anlage zum Ätzen von zumindest teilweise aus Metall, vorzugsweise Kupfer, bestehendem Ätzgut, vorzugsweise von gedruckten Leiterplatten, mit einem eine Säure, vorzugsweise Schwefelsäure, enthaltenden Ätzmittel, mit einer Ätzmaschine, welche eine Vielzahl von Düsen und einen Ätzmittelsumpf umfaßt, mit einer Pumpe, welche dem Ätzmittelsumpf Ätzmittel entnimmt und den Düsen über eine Einrichtung zuführt, in welcher dem Ätzmittel ein Oxidationsmittel und/oder Säure in stöchiometrischer Abhängigkeit von der Menge des abzuätzenden Metalls am jeweiligen Ätzgut zugegeben wird.

Eine derartige Anlage ist in der EP-A 00 53 719 beschrieben. Es fehlen jedoch sämliche Einzelheiten, wie die beschriebene Regelung bzw. Steuerung der Oxidationsmittelzugabe in der Praxis tatsächlich erfolgen soll. Wenn das gesteckte Ziel, die Konzentration des Oxidationsmittels in dem vom Ätzgut ablaufenden Ätzmittel so gering wie möglich zu halten tatsächlich erreicht werden soll, ist es erforderlich, die Anpassung der Oxidationsmittelzugabe wirklich exakt an die von Ätzgutart zu Ätzgutart variierende Menge des abzutragenden Materials anzupassen.

Aufgabe der vorliegenden Erfindung ist es, eine Anlage der eingangs genannten Art so auszugestalten, daß die erforderliche Anpassung der Oxidationsmittelzugabe bzw. Säurezugabe an das jeweils bearbeitete Ätzgut auch von wenig geschultem Personal problemlos und exakt durchgeführt werden kann.

Diese Aufgabe wird erfindungsgemäß dadurch gelöst, daß die Anlage umfaßt:

a) eine Einrichtung, welche mindestens ein erstes Signal abgibt, das Auskunft über die Menge des am jeweils bearbei teten Ätzgut abzuätzenden Metall gibt;

b) einen Detektor, welcher ein zweites Signal abgibt, wenn das jeweils bearbeitete Ätzgut in der Ätzmaschine einläuft;

c) eine zentrale Steuereinheit, welcher das erste und das zweite Signal zugeführt wird und die aus dem ersten Signal die entsprechende Menge Oxidationsmittel und/oder Säure besimmt und ein entsprechendes drittes Signal abgibt, wenn das zweite Signal eintrifft;

d) eine Dosiereinrichtung, welcher das dritte Signal zugeführt wird und eine diesem dritten Signal entsprechende Menge an Oxidationsmittel und/oder Säure einem Vorratstank entnimmt und dem von der Pumpe zu den Düsen geförderten Ätzmittel zugibt.

Bei einer erfindungsgemäßen Anlage werden somit in der Regel alle der Anpassung der Oxidationsmittelmenge bzw. der Säuremenge an die abzutragende Metallmenge dienenden Einstellungen weitestgehend automatisch vorgenommen, so daß keine Fehler des Bedienungspersonals auftreten können.

Die zentrale Steuereinheit kann das dritte Signal aus dem ersten nach einem fest vorgegebenen Algorithmus errechnen. In vielen Fällen ist eine proportionale Abhängigkeit angemessen und ausreichend, wobei der Proportionalitätsfaktor experimentell für die jeweilige Ätzmaschine und das jeweilige zu ätzende Metall ermittelt wird.

Alternativ kann die zentrale Steuereinheit dem ersten Signal das dritte Signal nach Tabellen zuordnen. die in einem Speicher der zentralen Steuereinheit abgelegt sind. Die Werte in der Tabelle werden wiederum experimentell für die jeweilige Ätzanlage sowie das zu bearbeitende Metall bestimmt.

Am komfortabelsten ist es, wenn die Einrichtung, die mindestens ein erstes Signal abgibt, eine optische Reflexions-Meßeinrichtung, welche die freiliegende Metallfläche am Ätzgut bestimmt, und eine Dicken-Meßeinrichtung, welche die Dicke der abzutragenden Metallschicht am Ätzgut bestimmt, umfaßt, wobei die zentrale Steuereinheit aus der freiliegenden Fläche und der Dicke der abzuätzenden Metallschicht die Menge des abzuätzenden Metalls errechnet. Bei dieser Ausgestaltung können wahllos die unterschiedlichsten Ätzgutarten hintereinander auf der Anlage bearbeitet werden, wobei eine besondere Aufmerksamkeit des Bedienungspersonals nicht erforderlich ist. Beim Ätzgut braucht es sich auch nicht um besonders typisierte, immer wiederkehrende Arten zu handeln.

Sollen jedoch auf der Anlage in erster Linie typisierte, immer wiederkehrende Ätzgutarten bearbeitet werden, empfiehlt es sich, daß die Einrichtung, welche mindestens ein erstes Signal abgibt, ein Lesegerät ist, welches einen am jeweils bearbeiteten Ätzgut angebrachten Code entziffert, wobei das erste Signal repräsentativ für den entzifferten Code ist.

Am einfachsten schließlich ist es, wenn die Einrichtung, welche mindestens ein erstes Signal abgibt, ein Tastenfeld ist, über welches ein Code für das jeweils bearbeitete Ätzgut bzw. die abzuätzende Metallmenge direkt von Hand in die zentrale Steuereinheit eingegeben werden kann. Diese Ausgestaltung wird dort eingesetzt, wo große Serien gleichbleibender Ätzgüter verarbeitet werden sollen und eine Umstellung auf eine andere Ätzgutart nur selten ist. In diesem Falle kann dann die Kennung für die Ätzgutart bzw. die Menge des bei dieser Ätzgutart abzutragenden Metalles von Hand eingegeben werden.

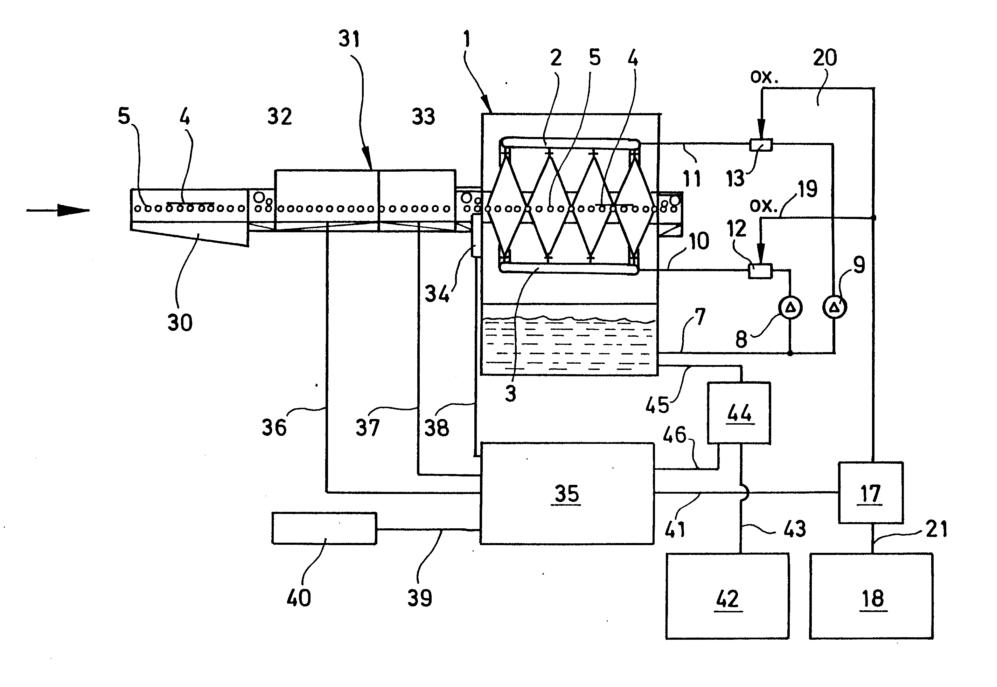

Ausführungsbeispiele der Erfindung werden nachfolgend anhand der Zeichnung näher erläutert; die einzige Figur zeigt schematisch eine Ätzanlage.

Die in der Zeichnung dargestellte Ätzanlage umfaßt einen Eingangsbaustein 30, in dem das Ätzgut 4 -beispielsweise gedruckte Leiterplatten - auf eine Rollenbahn 5 aufgelegt wird. Die Rollenbahn 5 befördert das Ätzgut in der Zeichnung von links nach rechts durch die gesamte Ätzanlage hindurch.

Das Ätzgut 4 gelangt aus dem Eingangsbaustein 30 zunächst in eine Einrichtung 31, in welcher die Menge des Metalles bestimmt wird, die bei dem jeweils in Bearbeitung befindlichen Ätzgut 4 abgetragen werden muß. Diese Einrichtung 31 enthält zunächst eine bekannte, handelsübliche optische Reflexions-Meßeinrichtung 32, die aus der Reflexion von Licht am Ätzgut 4 die freiliegende Metallfläche des Ätzgutes 4 ermittelt. Als nächstes durchläuft das Ätzgut 4 innerhalb der Einrichtung 31 eine Dickenmeßeinrichtung 33, die ebenfalls handelsüblich ist und die Dicke der abzutragenden Metallschicht am Ätzgut 4 bestimmt.

Darauf erfolgt der Eintritt des Ätzgutes 4 in die eigentliche Ätzmaschine 1, dessen Zeitpunkt durch einen Detektor 34 überwacht wird. Bei dem Detektor 34 kann es sich um eine (Reflexions-)Lichtschranke, einen Mikroschalter oder dergleichen handeln.

Die Ätzmaschine 1 besitzt einen oberen, eine Vielzahl von Düsen aufweisenden Düsenstock 2 und einen unteren, ebenfalls eine Vielzahl von Düsen aufweisenden Düsenstock 3. Das auf der Rollenbahn 5 fortbewegte Ätzgut 4 wird von oben und unten aus den Düsenstöcken 2 und 3 mit flüssigem, Schwefelsäure enthaltendem Ätzmittel besprüht.

Im unteren Bereich der Ätzmaschine 1 befindet sich ein Ätzmittelsumpf 6. Eine Entnahmeleitung 7 führt vom Ätzmittelsumpf 6 zur Saugseite zweier Pumpen 8 und 9, deren Auslaß über Leitungen 10 und 11 sowie über in den Leitungen 10 und 11 liegende Oxidationsmittel-Injektoren 12 und 13 mit den Düsenstöcken 3 bzw. 2 verbunden sind.

Eine zentrale Steuereinheit 35 ist über elektrische Leitungen 36, 37, 38 mit der optischen Reflexions-Meßeinrichtung 32, der Dickenmeßeinrichtung 33 sowie dem Detektor 34 verbunden und empfängt von diesen elektrische Signale, die den jeweiligen Meßwerten entsprechen. Die zentrale Steuereinheit 35 ist außerdem über eine Leitung 39 mit einem als Eingabeeinheit dienenden Tastenfeld 40 verbunden.

Das von der zentralen Steuereinheit 35 erzeugte Ausgangssignal liegt über eine Leitung 41 an einer Dosiereinrichtung 17 an. Diese entnimmt entsprechend dem übermittelten Ausgangssignal der zentralen Steuereinheit 35 über eine Leitung 21 Oxidationsmittel aus einem Vorratstank 18 und führt dieses über die Leitungen 19, 20 den Injektoren 12, 13 zu.

Die Funktionsweise der beschriebenen Ätzanlage ist wie folgt:

Ziel ist es, die dem Ätzmittel über die Injektoren 12, 13 für jeden einzelnen Ätzvorgang zuzusetzende Menge an Oxidationsmittel in einen bestimmten, stöchiometrischen Bezug zur Menge des abzuätzenden Metalles am Ätzgut 4 zu setzen. Dies kann in der Weise geschehen, daß die Oxidationsmittelmenge in exakter Stöchiometrie der Menge des abzuätzenden Metalles entspricht; alternativ ist es auch möglich, die Anlage mit einem kleinen "Sicherheitsüberschuß" an Oxidationsmittel, der über die stöchiometrisch erforderliche Menge hinausgeht, zu fahren. In beiden Fällen ist Sinn der Maßnahme, die Konzentration des Oxidationsmittels im Ätzmittel möglichst niedrig zu halten, da dieses den Betrieb der Umwälzpumpen oder einer Elektrolysezelle bei der Regeneration des Ätzmittels behindern könnte.

Zu dem geschilderten Zwecke empfängt die zentrale Steuerein heit 35 über die Leitungen 36 und 37 Daten (nämlich Fläche und Dicke der abzutragenden Metallschicht) von der Einrichtung 31, aus denen sich die Menge des abzuätzenden Metalls an dem Ätzgut 4 ermitteln läßt, welches jeweils gerade die Einrichtung 31 durchläuft und in der Ätzmaschine 1 geätzt werden soll. Nach einem eingespeicherten Programm ordnet die zentrale Steuereinheit 35 der ermittelten Menge abzutragenden Metalls die entsprechende Menge an Oxidationsmittel zu. Hierbei kann entweder in Anlehnung an die stöchiometrische Beziehung ein Algorithmus verwendet werden (z.B. eine lineare Abhängigkeit) oder die einander entsprechenden Mengen von abzutragendem Metall und Oxidationsmittel werden (empirischen) Tabellen entnommen, die in einem Speicher in der zentralen Steuereinheit 35 abgelegt sind.

Liefert der Detektor 34 an die zentrale Steuereinheit 35 nunmehr das Signal, welches das Einlaufen des jeweiligen Ätzgutes 4 in die Ätzmaschine 1 anzeigt, so gibt die zentrale Steuereinheit an die Dosiereinrichtung 17 ein Signal ab, welches für die Menge des erforderlichen Oxidationsmittels repräsentativ ist. Die Dosiereinrichtung 17 führt diesen Befehl aus, indem sie die entsprechende Oxidationsmittelmenge dem Vorratsbehälter 18 entnimmt und über die Injektoren 12, 13 dem von den Pumpen 8, 9 umgewälzten Ätzmittel zusetzt.

Das Tastenfeld 40 dient bei diesem Ausführungsbeispiel ausschließlich der Programmierung der zentralen Steuereinheit 35 sowie der Eingabe der in dessen Speicher abzulegenden Daten.

Ein zweites, in der Zeichnung nicht dargestelltes Ausführungsbeispiel kommt vornehmlich dann zum Einsatz, wenn eine begrenzte Anzahl typisierter Ätzgutarten in der Anlage bearbeitet werden soll. In diesen Fällen wird die komplizierte, aus der Reflexionseinrichtung 32 und der Dickenmeßeinrichtung 33 zusammengesetzte Einrichtung 31 durch ein preiswerteres Lesegerät ersetzt, welches in der Lage ist, einen auf dem Ätzgut 4 jeweils aufgebrachten Code bei dessen Durchlauf zu erkennen. Das Lesegerät gibt dann ein dem Code entsprechendes Signal an die zentrale Steuereinheit 35, welche aus in ihrem Speicher abgelegten Tabellen die diesem Code, der ja eine bestimmte abzutragende Metallmenge symbolisiert, entsprechende Oxidationsmittelmenge zuordnet. Die übrigen Funktionen des zweiten Ausführungsbeispiels stimmen mit denjenigen des zuerst beschriebenen Ausführungsbeispiels überein.

Eine dritte, ebenfalls in der Zeichnung nicht dargestellte Ausführungsform kommt dort zum Einsatz, wo größere Ätzgutserien bearbeitet werden sollen und eine Umstellung von einer Ätzgutart zur anderen daher nur relativ selten erfolgen muß. Hier kann auf die Verwendung eines automatisch arbeitenden Gerätes zur Identifizierung der Ätzgutart bzw. der Menge des abzutragenden Metalles verzichtet werden. Stattdessen wird bei der Umstellung von einer Ätzgutart auf die andere ein entsprechender Code von Hand über das Tastenfeld 40 in die zentrale Steuereinheit 35 eingegeben. Diese ordnet wiederum anhand abgespeicherter Tabellen dem eingegebenen Code die entsprechende Menge an Oxidationsmittel zu und gibt ein entsprechendes Signal an die Dosiereinrichtung 17 ab. In diesem preisgünstigen Falle ist also das Tastenfeld 40 als diejenige Einrichtung anzusehen, welche Auskunft über die Menge des abzutragenden Metalls am jeweils bearbeiteten Ätzgut 4 gibt.

Mit den bisher noch nicht beschriebenen Zeichnungselementen 42 bis 46 hat es folgende Bewandnis:

Im allgemeinen wird beim Ätzen von Metall nicht nur Oxidationsmittel sondern auch Säure im Ätzmittel verbraucht. Sofern keine elektrolytische Regeneration des Ätzmittels vorgesehen ist, muß also im Verlaufe des Ätzvorganges Säure zu gegeben werden. Dies kann stöchiometrisch in genau derselben Weise geschehen, wie dies oben für die stöchiometrische Zugabe von Oxidationsmittel beschrieben wurde:

Die zentrale Steuereinheit erzeugt nach einem inneren Programm oder nach abgespeicherten Tabellen aus dem oder den Eingangssignalen, welche die Menge des abzuätzenden Metalles angeben, auf der Leitung 46 ein zweites Ausgangssignal, welches der Menge der entsprechend zuzugebenden Säure entspricht. Das zweite Ausgangssignal beaufschlagt eine zweite Dosiereinrichtung 44, welche aus einem Vorratstank 42 über die Leitung 43 die fragliche Säuremenge entnimmt und über die Leitung 45 dem Sumpf der Ätzmaschine 1 zuführt.

Der Begriff des "Ätzens" wurde vorstehend in einer Weise verwendet, die nicht nur das vollständige Durchätzen einer Metallschicht sondern auch das Anätzen eines Metalles bis zu einer bestimmten Tiefe beinhaltet.

## Ansprüche

1. Anlage zum Ätzen von zumindest teilweise auf Metall, vorzugsweise Kupfer, bestehendem Ätzgut, vorzugsweise von gedruckten Leiterplatten, mit einem eine Säure, vorzugsweise Schwefelsäure, enthaltenden Ätzmittel, mit einer Ätzmaschine, welche eine Vielzahl von Düsen und einen Ätzmittelsumpf umfaßt, mit einer Pumpe, welche dem Ätzmittelsumpf Ätzmittel entnimmt und den Düsen über eine Einrichtung zuführt, in welcher dem Ätzmittel ein Oxidationsmittel und/oder Säure in stöchiometrischer Abhängigkeit von der Menge des abzuätzenden Metalls am jeweiligen Ätzgut zugegeben wird, dadurch gekennzeichnet, daß sie umfaßt:

a) eine Einrichtung (31), welche mindestens ein erstes Signal abgibt, das Auskunft über die Menge des am jeweils bearbeiteten Ätzgut (4) abzuätzenden Metalls gibt;

b) einen Detektor (34), welcher ein zweites Signal abgibt, wenn das jeweils bearbeitete Ätzgut (4) in die Ätzmaschine (1) einläuft;

c) eine zentrale Steuereinheit (35), welcher das erste und das zweite Signal zugeführt werden und die aus dem ersten Signal die entsprechende Menge Oxidationsmittel und/oder Säure bestimmt und ein entsprechendes drittes Signal abgibt, wenn das zweite Signal eintrifft;

d) eine Dosiereinrichtung (17), welcher das dritte Signal zugeführt wird und eine diesem dritten Signal entsprechende Menge an Oxidationsmittel und/oder Säure einem Vorratstank (18) entnimmt und dem von der Pumpe (8, 9) zu den Düsen (2, 3) geförderten Ätzmittel zugibt.

2. Anlage nach Anspruch 1, dadurch gekennzeichnet, daß die zentrale Steuereinheit (35) das dritte Signal aus dem ersten Signal nach einem fest vorgegebenen Algorithmus errechnet.

3. Anlage nach Anspruch 1, dadurch gekennzeichnet, daß die zentrale Steuereinheit (35) dem ersten Signal das dritte Signal nach Tabellen zuordnet, die in einem Speicher der zentralen Steuereinheit (35) abgelegt sind.

4. Anlage nach einem der Ansprüche 1 bis 3, dadurch gekennzeichnet, daß die Einrichtung (31), die mindestens ein erstes Signal abgibt, eine optische Reflexions-Meßeinrichtung (32), welche die freiliegende Metallfläche am Ätzgut (4) bestimmt, und eine Dicken-Meßeinrichtung (33), welche die Dicke der abzutragenden Metallschicht am Ätzgut (4) bestimmt, umfaßt, wobei die zentrale Steuereinheit (35) aus der freiliegenden Fläche und der Dicke der abzutragenden Metallschicht die Menge des abzuätzenden Metalls errechnet.

5. Anlage nach Anspruch 1 oder 3, dadurch gekennzeichnet, daß die Einrichtung, welche mindestens ein erstes Signal abgibt, ein Lesegerät ist, welches einen am jeweils bearbeiteten Ätzgut (4) angebrachten Code entziffert, wobei das erste Signal repräsentativ für den entzifferten Code ist.

6. Anlage nach Anspruch 1 oder 3, dadurch gekennzeichnet, daß die Einrichtung, welche mindestens ein erstes Signal abgibt, ein Tastenfeld ist, über welches ein Code für das jeweils bearbeitete Ätzgut bzw. die abzuätzende Metallmenge direkt von Hand in die zentrale Steuereinheit (35) eingegeben werden kann.